(19) Europäisches Patentamt / European Patent Office / Office européen des brevets

(11) **EP 4 235 199 B1**

(12) **EUROPEAN PATENT SPECIFICATION**

(45) Date of publication and mention
of the grant of the patent:
**03.04.2024   Bulletin 2024/14**

(21) Application number: **22158236.4**

(22) Date of filing: **23.02.2022**

(51) International Patent Classification (IPC):
**G01R 31/392** (2019.01)     **G01R 31/367** (2019.01)
**G06N 20/00** (2019.01)

(52) Cooperative Patent Classification (CPC):
**G01R 31/392; G01R 31/367;** G06N 3/0455

(54) **ASSESSING PERFORMANCE OR STATE OR LOAD CONDITION OF A BATTERY STORAGE**

BEURTEILUNG DER LEISTUNG ODER DES ZUSTANDS ODER DER LADEBEDINGUNG EINES BATTERIESPEICHERS

ÉVALUATION DES PERFORMANCES OU DE L'ÉTAT OU DE LA CONDITION DE CHARGE D'UN STOCKAGE DE BATTERIE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**30.08.2023   Bulletin 2023/35**

(73) Proprietor: **Novum engineerING GmbH**
**01067 Dresden (DE)**

(72) Inventors:
• **Boß, Valentin**
  **01127 Dresden (DE)**
• **Saidani, Amin**
  **01279 Dresden (DE)**

(74) Representative: **Ter Meer Steinmeister & Partner**
**Patentanwälte mbB**
**Artur-Ladebeck-Strasse 51**
**33617 Bielefeld (DE)**

(56) References cited:
**WO-A1-2022/034116**     **CN-A- 113 917 334**
**DE-B4-102020 117 609**

• **JIN WEIHUA ET AL: "Analytical Investigation of Anomaly Detection Methods based on Time-Domain Features and Autoencoders in Satellite Power Subsystem", 2021 8TH INTERNATIONAL CONFERENCE ON DEPENDABLE SYSTEMS AND THEIR APPLICATIONS (DSA), IEEE, 5 August 2021 (2021-08-05), pages 451-460, XP034036155, DOI: 10.1109/DSA52907.2021.00068 [retrieved on 2021-11-19]**
• **HOMAYOUNI HAJAR ET AL: "An Autocorrelation-based LSTM-Autoencoder for Anomaly Detection on Time-Series Data", 2020 IEEE INTERNATIONAL CONFERENCE ON BIG DATA (BIG DATA), IEEE, 10 December 2020 (2020-12-10), pages 5068-5077, XP033888985, DOI: 10.1109/BIGDATA50022.2020.9378192 [retrieved on 2021-03-12]**

## Description

The invention relates to determining an assessment indicator for assessing at least one of a performance, a state, and a load condition of a battery storage.

The capacity of a battery decreases over time. The loss of capacity may be expressed by the SOH (state of health), which is the ratio of the capacity at a given time t and its initial capacity. Thus, the SOH is an indicator of the performance of a battery. For example, an SOH of 0.8 (80%) means that the battery currently has lost 20% of its original capacity. To determine the SOH, a battery needs to be fully charged and discharged. This, however, is impractical.

Other methods for determining a performance of a battery use a measurement of the internal resistance of the battery, a measurement of impedance, or of other key performance indicators. Usually, those methods rely on laboratory measurements for fine tuning the methods. However, the battery behavior is heavily determined by its operating conditions, which cannot reasonably be exactly emulated in laboratory experiments. This may lead to drifting of those methods.

DE 10 2020 117609 B4 describes a method for processing condition data of a battery that includes applying an auto-encoder of an artificial neural network to initial state data. Reconstructed data is obtained therefrom. The method includes performing an ageing estimation on the basis of the reconstructed state data to obtain a state indicator which is indicative of an ageing condition of the battery.

"Analytical Investigation of Anomaly Detection Methods based on Time-Domain Features and Autoencoders in Satellite Power Subsystem" by Weihua et al., 2101 8TH INTERNATIONAL CONFERENCE ON DEPENDABLE SYSTEMS AND THEIR APPLICATIONS (DSA), IEEE, 5 August 2021, pages 451-460, XP034036155, DOI: 10.1109/DSA52907.2021.00068, investigates the potential of autoencoders in detecting anomalies in satellite power subsystem telemetry data.

"An Autocorrelation-based LSTM-Autoencoder for Anomaly Detection on Time-Series Data" by Hajar et al., 2020 IEEE INTERNATIONAL CONFERENCE ON BIG DATA (BIG DATA), IEEE, 10 December 2020, pages 5068-5077, XP033888985, DOI: 10.1109BIGDATA50022.2020.9378192, describes an LSTM-Autoencoder based approach that detects anomalies in multivariate time-series data, generates domain constraints, and reports subsequences that violate the constraints as anomalies.

WO 2022/034116 A1 describes a method for locally determining at least one characteristic value of a battery cell, wherein time series of voltages and time or another measure of a state-of-health indicator of a cell are supplied to a further neural network, wherein the further neural network is a network designed for sequence-to-sequence deep learning, and for obtaining a second indicator from the further neural network, wherein the second indicator is a further measure for the expected degradation of the cell.

CN 113 917 334 A discloses a battery health state estimation method based on an evolutionary LSTM auto-encoder.

## Summary of the Invention

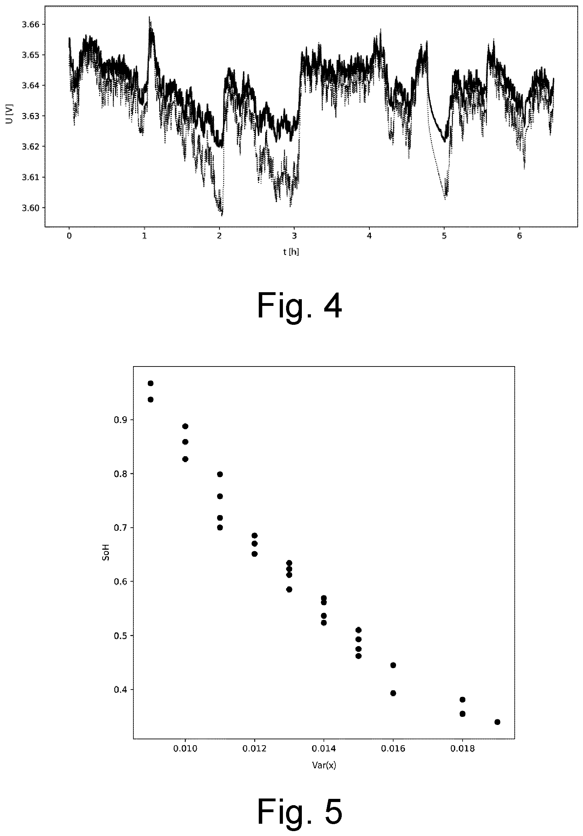

To reliably determine a performance or state of a battery is desirable in many applications. The problem of determining a battery state or performance becomes apparent, in particular, when considering modern large battery storage facilities used to stabilize the main power grid (PCR: Primary Control Reserve, or Primary Control Power). Battery storage facilities or systems, also called battery energy storage systems, are used for stabilizing the main power grid, in particular for primary control. Primary control is an automatic function for frequency control of an electric power system in a case of an unbalance between power generation and load. In this use case, batteries are operating at about 50% of their capacity most of the time and are rarely significantly charged or discharged. Here, the signals measured from a battery (such as current, voltage, temperature) are very similar for an old battery or a new battery, as is exemplarily shown in Fig. 4.

It is an object of the invention to provide a novel method of determining an assessment indicator for assessing at least one of a performance, a state, and a load condition of a battery storage.

It is a further object of the invention to provide a novel method of monitoring at least one of a performance, a state, and a load condition of a battery storage.

The invention is indicated in the independent claims. Further aspects and embodiments are indicated in the dependent claims.

According to one aspect of the invention, there is provided a method of determining an assessment indicator for assessing at least one of a performance, a state and a load condition of a battery storage, the method comprising:

   obtaining a series of measurements of at least one physical parameter of the battery storage, the measurements corresponding to successive points of time of a time segment, wherein the at least one physical parameter includes at least one of voltage and current;
   inputting the series of measurements to an encoder of an autoencoder;
   receiving a reconstructed series of measurements from a decoder of the autoencoder;
   calculating a value of a reconstruction error based on the series of measurements and the reconstructed series of measurements; and
   determining an assessment indicator for assessing at least one of a performance, a state, and a load condition of the battery storage based on the calculated value of the reconstruction error.

The terms "performance of a battery storage" and "state of a battery storage" may each include a performance capability or service capability, the capacity, and/or the state of health (SoH) of the battery storage. In particular, the assessment indicator may be an assessment indicator for assessing at least one of a performance, a state and a load condition of a battery storage different from the state of charge of the battery storage. Said at least one of a performance, a state and a load condition of a battery storage may be substantially independent of the state of charge of the battery storage. The performance or state of the battery storage may deteriorate over time.

The term "load condition of a battery storage" refers to characteristics of the load that is applied to the battery storage, for example, characteristics of a load condition scenario. Typically, for a primary control reserve (PCR) battery storage of a power system, the load condition does not change over time, or is only temporarily different from an initial or typical load condition.

A trained autoencoder is able to reconstruct signals it was trained on quite well. Thus, when applied to the training data, the reconstructed signals have a small reconstruction error. However, when new patterns appear in new measured data, the autoencoder may fail to compress and decompress them properly. The more new patterns appear, the harder it gets for the autoencoder to do the reconstruction properly. Thus, changes of the performance or state and/or the load condition may be assessed based on the reconstruction error. For example, by monitoring the reconstruction error and comparing it to the training reconstruction error, changes in the battery state may be detected. Thus, the determined assessment indicator may indicate that the performance or state and/or the load condition of the battery storage is different from an initial situation (for example, different from what has occurred within a training period of the autoencoder), or has changed over time, for example, when the assessment indicator is compared to assessment indicators determined for previous, earlier time segments. In particular, monitoring the reconstruction error may allow to detect sudden, large changes that are due to, for example, a defect. For example, the calculated value of the reconstruction error may be determined as the assessment indicator.

It is particularly advantageous that the necessary measurements may be performed while the battery storage is in operation. That is, for example, no laboratory measurements are required. The method may rely on field data, or may rely only on field data. Moreover, the method is flexible and easy to use. The method may be applied to all kind of battery storages, including a single battery as well as a large battery storage facility. The method may be tuned to the smallest measurable unit (battery storage) of a battery storage system, that is, the smallest unit for which the at least one physical parameter is measurable and available.

In the invention, said steps of obtaining, inputting, receiving, and calculating are performed for multiple time segments of an evaluation period, wherein for each time segment, in the obtaining step, a series of measurements of the at least one physical parameter of the battery storage is obtained, the measurements corresponding to successive points of time of the time segment, and wherein the method comprises: calculating an indicator that is indicative of the variance of at least some of the calculated values of the reconstruction error and determining this indicator as the assessment indicator for assessing at least one of a performance, a state, and a load condition of the battery storage.

In other words, according to an aspect of the invention, there is provided a method of determining an assessment indicator for assessing at least one of a performance, a state, and a load condition of a battery storage, the method comprising:

> obtaining a series of measurements of at least one physical parameter of the battery storage, the measurements corresponding to successive points of time of a time segment, wherein the at least one physical parameter includes at least one of voltage and current;
> inputting the series of measurements to an encoder of an autoencoder;
> receiving a reconstructed series of measurements from a decoder of the autoencoder; and
> calculating a value of a reconstruction error based on the series of measurements and the reconstructed series of measurements,
> wherein said steps of obtaining, inputting, receiving, and calculating are performed for multiple time segments of an evaluation period, wherein for each time segment, in the obtaining step, a series of measurements of the at least one physical parameter of the battery storage is obtained, the measurements corresponding to successive points of time of the time segment,
> wherein the method further comprises:
> calculating an indicator that is indicative of the variance of at least some of the calculated values of the reconstruction error and determining this indicator as the assessment indicator for assessing at least one of a performance, a state, and a load condition of a battery storage.

As explained above, when the performance or state of the battery storage is changing, this will show in the reconstruction error. However, the impact of a degradation of the battery storage on the reconstruction error of a series of measurements may be, in practice, very small and may fluctuate. By calculating an indicator that is indicative of the variance of at least some of the calculated values of the reconstruction error for multiple time segments of an evaluation period, an indicator may be provided that is useful for assessing even small changes of a performance or state of the battery storage, or small changes of a (variation of a) load condition of the battery storage. In particular, the variance of the reconstruction error may be sensitive to changes in the operation of the battery storage that could not be reliably detected from the small and fluctuating magnitude of the reconstruction error. Thus, even small changes of the performance or state and/or the load condition may be reliably assessed.

Thus, for example, an automated battery storage state estimation based on the determined assessment indicator may be facilitated. Again, it is particularly advantageous that the necessary measurements may be performed while the battery storage is in operation. That is, for example, no laboratory measurements are required. The method may rely on field data, or may rely only on field data. Moreover, the method is flexible and easy to use. The method may be applied to all kind of battery storages, including a single battery as well as a large battery storage facility. The method may be tuned to the smallest measurable unit (battery storage) of a battery storage system, that is, the smallest unit for which the at least one physical parameter is measurable and available.

The determined assessment indicator may indicate that the performance or state and/or the load condition of the battery storage is different from an initial situation (for example, different from what has occurred within a training period of the autoencoder), or has changed over time, for example, when the assessment indicator is compared to an assessment indicator determined for a previous, earlier evaluation period.

Thus, by the method of determining the assessment indicator, a new key performance indicator is provided using a data driven approach. Using the determined assessment indicator, it is made possible to infer the battery state development and determine the speed by which batteries are degrading. The assessment indicator may also be called a battery index and is a value that measures the degree to which a system has changed from its original state. Applied to batteries, if it stays unchanged, it indicates the battery hasn't lost capacity, or internal resistance is unchanged. If it increases, this means the battery has probably lost some capacity or its internal resistance has increased. Sudden jumps in its value indicate an evolving system failure. The assessment indicator is calculated using an artificial neural network (autoencoder) to represent the battery state. The neural network may be trained in an unsupervised manner since it is used as an autoencoder.

One or more of the above described aspects may include one or more of the following features.

The method may be a computer-implemented method. The method may include recording the measurements of the at least one physical parameter. The method may include outputting the determined assessment indicator by a user readable output device, such as a display screen or a number display.

The battery storage may comprise at least one battery, for example an electrical battery or electrochemical battery. Specifically, a battery is understood as defining a device consisting of one or more electrical or electrochemical cells with external electrical connections. The battery storage may be battery storage of a power system. In particular, the battery storage may be a primary control reserve (PCR) battery storage of a power system such as the main power grid. Thus, the battery storage may be a part of a large-scale accumulator storage system.

The measurements of at least one physical parameter of the battery storage may be measured (taken) under operating conditions of the battery storage. In other words, the measurements of at least one physical parameter of the battery storage may be measured in operation of the battery storage, that is, while the battery storage is in operation. For example, the measurements may be measured while the battery storage is in operation as (a part of) a primary control reserve of a power system (that is, the battery storage is wired as (or as a part of) the primary control reserve of the power system). Thus, the method may be a method of determining an assessment indicator for assessing at least one of a performance, a state, and a load condition of a battery storage in the field.

Thus, the measured voltage and/or current of the battery storage may be a voltage and/or current of the battery storage under operating conditions of the battery storage. Herein, the current of the battery storage denotes the current input to or output by the battery storage, wherein the sign of the current denotes the direction of current flow.

The variance $\sigma^2$ of N calculated values $x_i$, i = 1, ..., N, of the reconstruction error is defined as

$$\sigma^2 = \frac{1}{N} \sum_{i=1}^{N} (x_i - \mu)^2$$

wherein $\mu$ is the mean value (arithmetic mean) of the reconstruction errors $x_i$. The calculated indicator may be indicative of the variance of at least some of the calculated values of the reconstruction error. For example, the indicator may be calculated based on the variance of at least some of the calculated values of the reconstruction error. For example, the calculated indicator may be the variance of (at least some of) the calculated values of the reconstruction error.

For example, the calculated indicator may be the variance of a subset (a true subset) of the calculated values of the reconstruction error. For example, the subset may be selected to include the largest N of the calculated values of the reconstruction error, N being a predetermined number. For example, the subset may include a fixed number of the calculated values of the reconstruction error. For example, the dimension of the subset may be about half the number of time segments of the evaluation period. For example, the calculated indicator may be the variance of the largest N values of the calculated values of the reconstruction error, wherein N is a natural number that is less than the number of multiple time segments.

Obtaining the series of measurements may include measuring the series of measurements of the at least one physical parameter. Thus, the method may include the step of: measuring a series of measurements of at least one physical parameter of the battery storage, the measurements corresponding to successive points of time of a time segment, wherein the at least one physical parameter includes at least one of voltage and current. In particular, the step of obtaining may include or be the step of measuring. For example, the method may be a method of determining an assessment indicator for assessing at least one of a performance, a state, and a load condition of a battery storage under operating conditions of the battery storage, that is, while the battery storage is in operation.

For example, the measurements of the series of measurements of at least one physical parameter of the battery storage may correspond to successive points of time of a time segment, which points of time are substantially equally spaced. In other words, the measurements may be measured at a predetermined measurement rate or at equal time steps. For example, the measurements may be measured at a measurement rate that is one measurement per 10 seconds or higher, for example, one measurement per two seconds or higher, or preferably one measurement per second or higher. For example, the measurements may be measured at a measurement rate that is 10 measurements per second or lower, for example, two measurements per second or lower. Preferably, the measurement rate is in the range of 0.5 to 2 measurements per second.

For each of the time segments, the measurements of the respective series of measurements correspond to successive points of time of the time segment. In other words, the series of measurements is a time series. The measurements may be taken at the corresponding successive points of time. Each measurement may be a measurement of one physical parameter, or of two or more physical parameters.

The at least one physical parameter of the battery storage includes at least one of voltage and current. The at least one physical parameter of the battery storage may include a temperature. The at least one physical parameter of the battery storage may include at least one other operating parameter of the battery storage. The behavior of the voltage of the battery storage is particularly determined by the performance or state of the battery storage, for example, its state of health. Therefore, when the at least one physical parameter of the battery storage includes voltage, the calculated indicator may be particularly useful for assessing a performance or state of the battery storage. The behavior of the current of the battery storage is particularly determined by the (varying) load condition of the battery storage. Therefore, when the at least one physical parameter of the battery storage includes current, the calculated indicator may be particularly useful for assessing a load condition of the battery storage, such as a changed load condition or a novel kind of load condition or load condition scenario.

A value of the reconstruction error is calculated based on the series of measurements and the reconstructed series of measurements. For example, the value of a reconstruction error may be calculated based on comparing the reconstructed series of measurements to the (input) series of measurements. For example, the value of a reconstruction error may be calculated from the series of measurements and the reconstructed series of measurements using a time series comparison metric. For example, the value of a reconstruction error may be calculated as the mean average error or mean squared error. The construction error quantifies a difference between the series of measurements and the reconstructed series of measurements.

For example, when the at least one physical parameter includes at least two physical parameters, calculating the value of a reconstruction error may be based on weighted values of the physical parameters. That is, the physical parameters are weighted using associated weights. For example, voltage and current may have different associated weights, or temperature may have an associated weight that is different from an associated weight of voltage and/or current.

The indicator is calculated to be a numerical value. Therefore, calculating the indicator is different from simply determining whether there is an anomaly (a case of an error) or not. The indicator may be calculated dependent on the variance of at least some of the calculated values of the reconstruction error.

The calculated indicator is related to the time segment or, respectively, the evaluation period. The indicator may be determined as the assessment indicator for assessing at least one of a performance, a state, and a load condition of the battery storage in the evaluation period. For example, when the steps of the method are repeatedly performed for successive evaluation periods, and a respective assessment indicator is determined for the respective evaluation period, a (gradual) change of the assessment indicator may be evaluated. For example, a change of the assessment indicator may indicate a deterioration of the performance or state of the battery storage or a change of a load condition (load situation or load scenario) of the battery storage. In practice, the evaluation period may be, for example, one day or several days. For example, the evaluation period may be at least 12 hours, or at least one day. For example, the evaluation period may be one week or less. For example, there may be a gap between two successive evaluation periods. For example, the steps of the method may be repeatedly performed for one respective evaluation period per one day or per at least one day, and/or per one week or less.

For example, the evaluation periods may be non-overlapping periods.

The multiple time segments of the evaluation period may be adjoining time segments, or there may be at least one gap between successive time segments of the evaluation period. For example, the multiple time segments of the evaluation period may be separated by gaps. For example, the beginning of a first time segment of the evaluation period may be equal to the beginning of the evaluation period. For example, the end of a last time segment of the evaluation period may be equal to the end of the evaluation period. For example, the total duration of the time segments of the evaluation period may be equal to the duration of the evaluation period. Preferably, the multiple time segments of the evaluation period are non-overlapping time segments.

For example, the duration of the time segment may be at least one minute, at least two minutes, or at least 5 minutes. For example, the duration of the time segment may be one hour or less, 10 hours or less, 12 hours or less, or 24 hours or less. For example, the multiple time segments of the evaluation period may each have a similar duration.

The steps of obtaining, inputting, receiving, and calculating are performed for multiple time segments of an evaluation period. For example, the steps are performed for a number of time segments of an evaluation period, said number being at least 5, or at least 8, preferably at least 10. For example, said number is 100 or less, 30 or less, or preferably 20 or less. For example, the number may be 10.

For example, the respective series of measurements may each have a same length. However, the method may comprise: padding and/or masking the series of measurements to establish a predetermined length of the series. The padding and/or masking may be performed before the step of inputting. The step of inputting may comprise padding and/or masking the series of measurements to establish a predetermined length of the series. The predetermined length may correspond to a dimension of an input layer of the auto-encoder, for example, an input layer of the encoder of the autoencoder.

The series of measurements that is input to the encoder of the autoencoder may also be called an input signal or input vector. The reconstructed series of measurements that is received from the decoder of the autoencoder may also be called an output signal or output vector. The length of the input series of measurements (the dimension of the input vector) may, for example, be at least 400, or at least 800, or at least 1500, or preferably at least 3000. The length of the input series of may, for example, be 100.000 or less, 10.000 or less, or preferably 5.000 or less. For example, the length may be 3600. In this case, the series is a series of 3600 measurements of the at least one physical parameter.

An autoencoder is an artificial neural network that includes an encoder and a decoder. For example, the autoencoder may be a recurrent neural network or a convolutional neural network (CNN). The autoencoder includes an internal layer (latent space) for holding or providing an internal representation of the input series of measurements. The internal representation is an encoded or compressed state of the input series of measurements. The latent space has a dimension that is lower than a dimension of an input layer or an output layer of the autoencoder. In particular, the method may comprise: mapping, by the encoder of the autoencoder, the input series of measurements to an internal representation thereof; and mapping, by the decoder of the autoencoder, the internal representation of the input series of measurements to a reconstructed series of measurements. This reconstructed series of measurements is then received from the decoder.

In embodiments, the autoencoder comprises:

a masking layer of the encoder for padding and/or masking the series of measurements input to the input layer of the encoder, and
an internal layer having a dimension that is lower than a dimension of the input layer of the encoder, wherein the method comprises:

mapping, by the encoder of the autoencoder, the input series of measurements to an internal representation thereof in the internal layer, and mapping, by the decoder of the autoencoder, the internal representation of the input series of measurements to a reconstructed series of measurements.

The internal layer may be a hidden layer.

In embodiments, the method is a method of determining an assessment indicator for assessing a performance or state of a battery storage, and wherein the least one physical parameter includes voltage.

In embodiments, the method is a method of determining an assessment indicator for assessing a load condition of a battery storage, and wherein the least one physical parameter includes current.

In embodiments, the method is a method of determining an assessment indicator for assessing a performance or state of a battery storage, and wherein the least one physical parameter includes voltage and current, and wherein the method comprises:

calculating a first value of a reconstruction error based on the measurements of current of the series of measurements of at least one physical parameter of the battery storage and on the reconstructed measurements of current of the reconstructed series of measurements; and
determining a first assessment indicator for assessing a load condition of the battery storage based on the calculated first value of the reconstruction error.

The method may comprise calculating a second value of a reconstruction error based at least on the measurements of voltage of the series of measurements of at least one physical parameter of the battery storage and at least on the reconstructed measurements of voltage of the reconstructed series of measurements, wherein the assessment indicator for assessing a performance or state of the battery storage is determined based on the calculated second value of the reconstruction error. For example, the step of calculating a second value of a reconstruction error may be performed if the first assessment indicator has not reached an associated first critical value. The method may comprise: if the first assessment indicator has reached the associated first critical value, outputting an error signal.

For example, when the steps of obtaining, inputting, receiving, and calculating are performed for multiple time segments of an evaluation period as described above, the method may comprise calculating a first assessment indicator that is indicative of the variance of at least some of the calculated first values of the reconstruction error. The method may further comprise: calculating an indicator that is indicative of the variance of at least some of the calculated second values of the reconstruction error and determining this indicator as the assessment indicator for assessing a performance or state of the battery storage. For example, a time segment or a part of a time segment may be excluded from calculating the second value of a reconstruction error, and/or from calculating an indicator that is indicative of the variance of at least some of the calculated second values of the reconstruction error, based on the first assessment indicator and/or a respective first value of the reconstruction error. Thus, those parts of the measurements that correspond to a non-regular current or load condition may be excluded from determining the assessment indicator for assessing a performance or state of the battery storage.

Thus, an evaluation of the current measurements may be performed. A non-typical or irregular load condition may be detected if the first assessment indicator reaches the associated first critical value, and this may be indicated by outputting the error signal. If, based on the current reconstruction, the load condition is assessed as being typical or non-critical, the assessment indicator for assessing a performance or state of a battery storage may be determined. Thus, the assessment indicator for assessing a performance or state of a battery storage may be determined with high reliability. Moreover, a reliability of the determined assessment indicator for assessing a performance or state of a battery storage may be determined based on the first value of the reconstruction error. The first value of a reconstruction error may be called a first value of a current reconstruction error.

In embodiments, the method further comprises: determining a state of health of the battery storage based on the calculated indicator and based on a reference value. The reference value may define a relation between a value of the indicator (calculated indicator, or assessment indicator) and the state of health. For example, a reference value of the state of health may be associated with a specific value of the indicator.

According to another aspect of the invention, there is provided a method of monitoring at least one of a performance, a state, and a load condition of a battery storage, the method comprising:

determining an assessment indicator for assessing the at least one of a performance, a state, and a load condition of the battery storage in accordance with the method of any one of the preceding claims 1 to 9, for a time segment or for an evaluation period; repeating the step of determining the assessment indicator for a new time segment or for a new evaluation period, as long as the determined assessment indicator has not yet reached an associated critical value; and outputting an error signal if the determined assessment indicator has reached the associated critical value.

The method may be a computer-implemented method. The time segment or the evaluation period may be a current time segment or current evaluation period, and the step of determining the assessment indicator may be repeated for a new current time segment or new current evaluation period. For example, the critical value may be defined based on a standard deviation or variance of reconstruction errors of training data of the autoencoder. The error signal may be output by a user readable output device. The error signal may be output to a user (operator).

The autoencoder may be a trained autoencoder. However, the method may further comprise: training the autoencoder using series of measurements of the at least one physical parameter of the battery storage, wherein the measurements of each series of measurements correspond to successive points of time of an associated training time segment of multiple training time segments of a training period. For example, the training period may be 1 month or longer, or 3 months or longer, or, for example, 6 months or longer. The training is performed initially. That is, the steps of inputting the series of measurements to an encoder of an autoencoder and receiving a reconstructed series of measurements from a decoder of the autoencoder are performed using the trained autoencoder. Preferably, the above described parameters of the series of measurements of a time segment (in particular, of a time segment of the evaluation period) are similar to the parameters of each series of measurements used in the training. For example, the measurement rate of the series of measurements used in the training may be similar to the measurement rate for the evaluation period. For example, the length of each series of measurements used in the training may be similar to the length of the series of measurement used in the evaluation period. For example, a training time segment corresponding to a series of measurement used in the training may have a similar length as a time segment of the evaluation period. It is particularly advantageous that the necessary measurements for the training may be performed while the battery storage is in operation. That is, for example, no laboratory measurements are required. The training may rely on field data, or may rely only on field data. The training step may be a step of unsupervised training. The method may be a computer-implemented method.

According to another aspect of the invention, there is provided a system for determining an assessment indicator for assessing at least one of a performance, a state, and a load condition of a battery storage, the system comprising: computational means, wherein the computational means are configured for performing the steps of the method of any one of the preceding claims, wherein the computational means comprise the autoencoder.

The system may include the battery storage. Thus, the system may be a battery storage system. The system may be or may be comprised in a system for monitoring at least one of a performance, a state, and a load condition of a battery storage.

In one or more embodiments, the system further comprises: measuring means configured for measuring the at least one physical parameter of the battery storage. The measuring means may be configured for providing the series of measurements to the computational means. However, the measuring means may also be external to the system and may be, for example, included in the battery storage.

Preferred embodiments of the invention will now be described in conjunction with the drawings, in which:

Fig. 1    is a schematic illustration of a system and a method for determining an assessment indicator for a battery storage according to embodiments;

Fig. 2    is a schematic illustration of an autoencoder of the system of Fig. 1;

Fig. 3    schematically shows time segments of an evaluation period;

Fig. 4    is a schematic diagram of battery voltage measurements;

Fig. 5    is a schematic diagram of the state of health (SOH) and the variance of the reconstruction error determined for a measured battery dataset; and

Fig. 6    is a schematic diagram of loss in SOH and the variance of the reconstruction error determined from laboratory measurements.

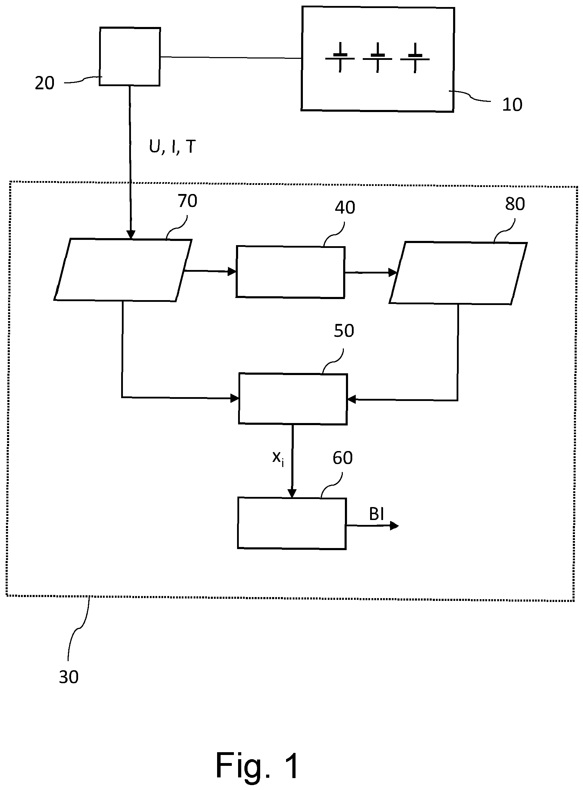

Fig. 1 schematically shows a battery storage 10, measuring means 20 and a system 30 for determining an assessment indicator for assessing at least one of a performance, a state, and a load condition of the battery storage 10. The system 30 includes an autoencoder 40, a reconstruction error calculating unit 50, and an indicator calculating unit 60.

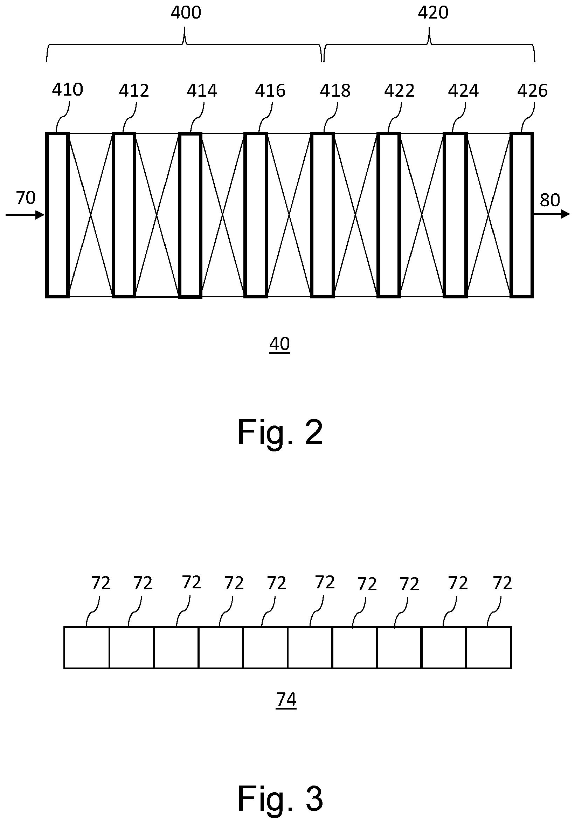

The autoencoder 40 is schematically shown in Fig. 2. The autoencoder 40 includes an encoder 400 having an input layer 410 having a dimension of N (for a series of N measurements of (U, I, T)), an optional masked layer 412 having a dimension of N, a first hidden layer 414 having a dimension of N/2, and a second hidden layer 416 having a dimension of N/4. The autoencoder 40 further includes a hidden encoded layer 418 (the latent space) having a dimension of N/8 and a decoder 420 having a first hidden layer 422 with a dimension of N/4, a second hidden layer 424 having a dimension of N/2, and an output layer 426 having a dimension of N. The hidden encoded layer 418 is a common layer of the encoder 400 and decoder 420. For example, N may be chosen as 3600. The encoder 400 maps (compresses) the input signals to a representation in the lower dimension space of the hidden encoded layer 418. The decoder 420 maps the representation (the encoded data) to the output signal. The output signal is a reconstruction of the input signal and may have the same dimension as the masked layer 412. From the input layer 410 to the masked layer 412, masking takes place in case the length of the input vector is smaller than the dimension of the masked layer 412.

The autoencoder 40 may be trained as follows. After gathering some field data from the battery storage (in this case, current I, voltage U, and temperature T), the autoencoder 40 may be trained to reconstruct these signals. For example, current I, voltage U, and temperature T may be measured and recorded. The signals are fed to the network of the autoencoder 40 as time series (series of measurements) of respective time segments. The autoencoder 40 learns to compress them and decompress them again. The autoencoder 40 consists of two parts, the encoder 400 and the decoder 420. The encoder part 400 maps the input signals into lower dimension space. It tries to learn a new, smaller representation of the data. The decoder 420 maps this representation again to the original input signal. Doing so, this neuronal network learns all patterns present in the input signals.

Returning to Fig. 1, in the method for determining an assessment indicator for a battery storage, the measuring means 20 measure voltage U, current I, and temperature T of the battery storage 10 and provides the measurements to the system 30. The system 30 records the measurements and provides respective series 70 of measurements to the auto-encoder 40.

Fig. 3 schematically shows ten adjoining time segments 72 of an evaluation period 74 having a duration of 10 hours. For example, for each time segment 72 having a duration of 1 hour, a series of 3600 measurements of U, I, T may be obtained that have been measured at a measuring rate of 1 measurement per second.

The autoencoder 40 processes the respective series 70 of measurements, including compressing or encoding them and decompressing or reconstructing a reconstructed series 80 of measurements. The reconstruction error calculating unit 50 calculates a reconstruction error x based on a comparison of the series 70 of measurements and the reconstructed series 80 of measurements. Any time series comparison metric may be used to compare the input and reconstructed signals. For example, the mean average error (mean absolute error) may be used. That is, for example, for a series having a length of L, the reconstruction error x is calculated as $x = 1/L \, \Sigma_{k=1,...,L} |M_k - R_k|$, wherein $M_k$ is the k-th measurement vector (U, I, T), and $R_k$ is the k-th reconstructed vector (U, I, T). As another example, the mean squared error may also be used.

The reconstruction errors $x_i$ of the series 70 of measurements of the multiple time segments 72 of the evaluation period 74 are fed to the indicator calculating unit 60. The indicator calculating unit 60 calculates the variance of the reconstruction error x. The calculated variance is determined as a battery index or assessment indicator BI for assessing the performance or state of the battery storage 10.

The trained model (that is, the autoencoder 40) is able to reconstruct the signals it was trained on quite well. On the training data, the model has a small reconstruction error. The trained model is used on the new data (series of measurements 70), and the reconstruction error may be monitored. Monitoring may include determining the assessment indicator BI as described above. In particular, the variance of the reconstruction error x, that is, the assessment indicator BI, may be monitored. When new patterns appear in the new data, the autoencoder 40 may fail to compress and decompress them properly. And the more new patterns appear, the harder it gets for the model to do the reconstruction properly. By monitoring this reconstruction error and comparing it to the training reconstruction error, or, more specifically, by monitoring the variance and comparing the variance (assessment indicator BI) to the training variance, even very small changes in the battery state may be detected.

Fig. 4 exemplarily shows series of voltage measurements of two battery cells having different SOH (90% and 80%) under PCR current load. The measurements show no significant differences. As shown in Fig. 4, the measured signals almost look the same for an old battery (thin chained line) or a new battery (thick line).

The method for determining the assessment indicator has been applied to an openly published battery dataset measured by the NASA. The results are represented in Fig. 5. The correlation between the variance Var(x) of the encoding error and the state of health SOH has been calculated. A high correlation of 97% has been found. Thus, the method has been validated.

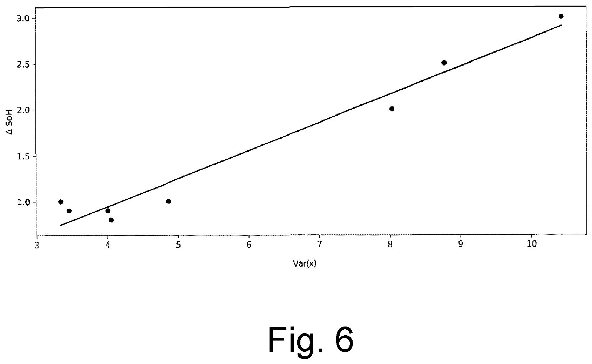

A new dataset was measured using a PCR profile (PCR current profile) in the laboratory. A batch was composed of 8 batteries with different states of health that were subjected to the PCR profile for some time. These batteries were then charged and discharged for a while to lose some capacity. Then the current was set to the PCR profile again. The autoencoder was trained on the initial PCR data. The variance of the reconstruction error was calculated using the second PCR data. A separate capacity measurement was conducted. Comparing the variance of the encoding error and capacity loss, the two values appeared to be highly correlated. This experience is very similar to the case of a large battery storage. The results are represented in Fig. 6, showing ΔSoH (loss of SOH) over the variance Var(x) of the encoding error. A linear fit is shown as a line.

Thus, the determined assessment indicator (battery index) BI highly correlates to the state of health (SOH). This means there exists a linear transformation SOH(BI) = $a * BI + a$, by which the SOH can be calculated from the indicator. Therefore, the parameters a, b can be calculated if some SOH values are available by performing linear regression of the relation of BI and SOH. Thus, the reference value (a, b) defines a relation between the assessment indicator BI and the state of health.

Similar to the above example of Fig. 1, in another example, the reconstruction error calculating unit 50 may further calculate a current reconstruction error based on the values of current I, the indicator calculating unit 60 may calculate the variance of the current reconstruction error, and the system 30 may determine whether the variance of the current reconstruction error is within a non-critical range. The variance of the current reconstruction error may indicate a reliability of the determined battery index or assessment indicator BI for assessing the performance or state of the battery storage 10.

## Claims

1. A method of determining an assessment indicator for assessing at least one of a performance, a state, and a load condition of a battery storage, the method comprising:

    obtaining a series (70) of measurements of at least one physical parameter of the battery storage (10), the measurements corresponding to successive points of time of a time segment (72), wherein the at least one physical parameter includes at least one of voltage and current;
    inputting the series (70) of measurements to an encoder (400) of an autoencoder (40);
    receiving a reconstructed series (80) of measurements from a decoder (420) of the autoencoder (40); and
    calculating a value of a reconstruction error (x) based on the series (70) of measurements and the reconstructed series (80) of measurements, wherein said steps of obtaining, inputting, receiving, and calculating are performed for multiple time segments (72) of an evaluation period (74), wherein for each time segment (72), in the obtaining step, a series (70) of measurements of the at least one physical parameter of the battery storage (10) is obtained, the measurements corresponding to successive points of time of the time segment (72),

wherein the method further comprises:

calculating an indicator that is indicative of the variance of at least some of the calculated values of the reconstruction error (x) and determining this indicator as an assessment indicator (BI) for assessing at least one of a performance, a state, and a load condition of the battery storage (10).

2. The method of claim 1, wherein the calculated indicator is the variance of at least some of the calculated values of the reconstruction error (x).

3. The method of claim 1 or 2, wherein the calculated indicator is the variance of the largest N values of the calculated values of the reconstruction error (x), wherein N is a natural number that is less than the number of multiple time segments (72).

4. The method of any one of the preceding claims, wherein said obtaining a series (70) of measurements of at least one physical parameter of the battery storage (10) includes measuring the series (70) of measurements of the at least one physical parameter of the battery storage (10).

5. The method of any one of the preceding claims, wherein the autoencoder (40) comprises:

   a masking layer (412) of the encoder (400) for padding and/or masking the series (70) of measurements input to the input layer (410) of the encoder (400), and
   an internal layer (418) having a dimension that is lower than a dimension of the input layer (410) of the encoder (400),

   wherein the method comprises:

   mapping, by the encoder (400) of the autoencoder (40), the input series (70) of measurements to an internal representation thereof in the internal layer (418), and
   mapping, by the decoder (420) of the autoencoder (40), the internal representation of the input series (70) of measurements to a reconstructed series (80) of measurements.

6. The method of any one of claims 1 to 5, wherein the method is a method of determining an assessment indicator for assessing a performance or state of a battery storage, and wherein the least one physical parameter includes voltage.

7. The method of any one of claims 1 to 5, wherein the method is a method of determining an assessment indicator for assessing a load condition of a battery storage, and wherein the least one physical parameter includes current.

8. The method of any one of the preceding claims, wherein the method further comprises: determining a state of health of the battery storage (10) based on the calculated indicator and based on a reference value.

9. A method of monitoring at least one of a performance, a state, and a load condition of a battery storage, the method comprising:

   determining an assessment indicator for assessing the at least one of a performance, a state, and a load condition of the battery storage (10) in accordance with the method of any one of the preceding claims 1 to 8, for an evaluation period (74);
   repeating the step of determining the assessment indicator for a new evaluation period (74), as long as the determined assessment indicator has not yet reached an associated critical value; and
   outputting an error signal if the determined assessment indicator has reached the associated critical value.

10. The method according to any one of the preceding claims, wherein the method further comprises: training the autoencoder (40) using series of measurements of the at least one physical parameter of the battery storage (10), wherein the measurements of each series of measurements correspond to successive points of time of an associated training time segment of multiple training time segments of a training period.

11. A system for determining an assessment indicator for assessing at least one of a performance, a state, and a load condition of a battery storage, the system comprising:
computational means (30), wherein the computational means (30) are configured for performing the steps of the method of any one of the preceding claims, wherein the computational means (30) comprise the autoencoder (40).

**Patentansprüche**

1. Ein Verfahren des Bestimmens eines Beurteilungsindikators zum Beurteilen wenigstens eines von einer Leistung, einem Zustand und einer Lastbedingung eines Batteriespeichers, das Verfahren umfassend:

   Erhalten einer Reihe (70) von Messungen wenigstens eines physikalischen Parameters des Batteriespeichers (10), wobei die Messungen aufeinanderfolgenden Zeitpunkten eines Zeitsegments (72) entsprechen, wobei der wenigstens eine physikalische Parameter zumindest eines von Spannung und Strom umfasst;
   Eingeben der Reihe (70) von Messungen in einen Encoder (400) eines Autoencoders (40);
   Empfangen einer rekonstruierten Reihe (80) von Messungen von einem Decoder (420) des Autoencoders (40); und
   Berechnen eines Werts eines Rekonstruktionsfehlers (x), basierend auf der Reihe (70) von Messungen und der rekonstruierten Reihe (80) von Messungen,
   wobei die besagten Schritte des Erhaltens, Eingebens, Empfangens und Berechnens für mehrere Zeitsegmente (72) eines Bewertungszeitraums (74) durchgeführt werden, wobei für jedes Zeitsegment (72) in dem Schritt des Erhaltens eine Reihe (70) von Messungen des wenigstens einen physikalischen Parameters des Batteriespeichers (10) erhalten wird, wobei die Messungen aufeinanderfolgenden Zeitpunkten des Zeitsegments (72) entsprechen,
   wobei das Verfahren weiter umfasst:
   Berechnen eines Indikators, der bezeichnend ist für die Varianz wenigstens einiger der berechneten Werte des Rekonstruktionsfehlers (x), und Bestimmen dieses Indikators als einen Beurteilungsindikator (BI) zum Beurteilen wenigstens eines von einer Leistung, einem Zustand und einer Lastbedingung des Batteriespeichers (10).

2. Das Verfahren nach Anspruch 1, wobei der berechnete Indikator die Varianz von wenigstens einigen der berechneten Werte des Rekonstruktionsfehlers (x) ist.

3. Das Verfahren nach Anspruch 1 oder 2, wobei der berechnete Indikator die Varianz der N größten Werte der berechneten Werte des Rekonstruktionsfehlers (x) ist, wobei N eine natürliche Zahl ist, die kleiner ist als die Anzahl der mehreren Zeitsegmente (72).

4. Das Verfahren nach einem der vorstehenden Ansprüche, wobei das besagte Erhalten einer Reihe (70) von Messungen wenigstens einen physikalischen Parameters des Batteriespeichers (10) umfasst: Messen der Reihe (70) von Messungen des wenigstens einen physikalischen Parameters des Batteriespeichers (10).

5. Das Verfahren nach einem der vorstehenden Ansprüche, wobei der Autoencoder (40) umfasst:

   eine Maskierungsschicht (412) des Encoders (400) zum Auffüllen und/oder Maskieren der Reihe (70) von Messungen, die in die Eingabeschicht (410) des Encoders (400) eingegeben wird, und
   eine interne Schicht (418) mit einer Dimension, die niedriger ist als eine Dimension der Eingabeschicht (410) des Encoders (400),
   wobei das Verfahren umfasst:

   Abbilden, durch den Encoder (400) des Autoencoders (40), der eingegebenen Reihe (70) von Messungen auf eine interne Repräsentation davon in der internen Schicht (418) und
   Abbilden, durch den Decoder (420) des Autoencoders (40), der internen Repräsentation der eingegebenen Reihe (70) von Messungen auf eine rekonstruierte Reihe (80) von Messungen.

6. Das Verfahren nach einem der Ansprüche 1 bis 5, wobei das Verfahren ein Verfahren des Bestimmens eines Beurteilungsindikators zum Beurteilen einer Leistung oder eines Zustands eines Batteriespeichers ist, und wobei der wenigstens eine physikalische Parameter Spannung umfasst.

7. Das Verfahren nach einem der Ansprüche 1 bis 5, wobei das Verfahren ein Verfahren des Bestimmens eines Beurteilungsindikators zum Beurteilen einer Lastbedingung eines Batteriespeichers ist, und wobei der wenigstens eine physikalische Parameter Strom umfasst.

8. Das Verfahren nach einem der vorstehenden Ansprüche, wobei das Verfahren weiter umfasst: Bestimmen eines Gesundheitszustands des Batteriespeichers (10), basierend auf dem berechneten Indikator und basierend auf einem Referenzwert.

9. Ein Verfahren zum Überwachen wenigstens eines von einer Leistung, eines Zustands und einer Lastbedingung eines Batteriespeichers, das Verfahren umfassend:

   Bestimmen eines Beurteilungsindikators zum Beurteilen des wenigstens einen von einer Leistung, einem Zustand und einer Lastbedingung des Batteriespeichers (10) gemäß dem Verfahren nach einem der vorstehenden Ansprüche 1 bis 8, für einen Bewertungszeitraum (74); Wiederholen des Schritts des Bestimmens des Beurteilungsindikators für einen neuen Bewertungszeitraum (74), solange der bestimmte Beurteilungsindikator noch nicht einen zugehörigen kritischen Wert erreicht hat; und Ausgeben eines Fehlersignals, wenn der bestimmte Beurteilungsindikator den zugehörigen kritischen Wert erreicht hat.

10. Das Verfahren nach einem der vorstehenden Ansprüche, wobei das Verfahren weiter umfasst: Trainieren des Autoencoders (40) unter Verwendung von Reihen von Messungen des wenigstens eines physikalischen Parameters des Batteriespeichers (10), wobei die Messungen jeder Reihe von Messungen aufeinanderfolgenden Zeitpunkten eines zugehörigen Trainingszeitsegments von mehreren Trainingszeitsegmenten eines Trainingszeitraums entsprechen.

11. Ein System zum Bestimmen eines Beurteilungsindikators zum Beurteilen wenigstens eines von einer Leistung, einem Zustand und einer Lastbedingung eines Batteriespeichers, das System umfassend: Berechnungsmittel (30), wobei die Berechnungsmittel (30) eingerichtet sind zum Durchführen der Schritte des Verfahrens nach einem der vorstehenden Ansprüche, wobei die Berechnungsmittel (30) den Autoencoder (40) umfassen.

**Revendications**

1. Procédé de détermination d'un indicateur d'évaluation pour évaluer au moins un élément parmi une performance, un état et une condition de charge d'un stockage de batterie, le procédé comportant les étapes consistant à :

obtenir une série (70) de mesures d'au moins un paramètre physique du stockage de batterie (10), les mesures correspondant à des points successifs dans le temps d'un segment temporel (72), dans lequel le au moins un paramètre physique inclut au moins un élément parmi une tension et un courant ; entrer la série (70) de mesures dans un encodeur (400) d'un auto-encodeur (40) ; recevoir une série reconstruite (80) de mesures provenant d'un décodeur (420) de l'auto-encodeur (400) ; et calculer une valeur d'une erreur de reconstruction (x) sur la base de la série (70) de mesures et de la série reconstruite (80) de mesures, dans lequel lesdites étapes d'obtention, d'entrée, de réception et de calcul sont réalisées pour de multiples segments temporels (70) d'une période d'évaluation (74), dans lequel pour chaque segment temporel (72), à l'étape d'obtention, une série (70) de mesures du au moins un paramètre physique du stockage de batterie (10) est obtenue, les mesures correspondant à des points successifs dans le temps du segment temporel (72), dans lequel le procédé comporte en outre de : calculer un indicateur qui est indicatif de la variance d'au moins certaines des valeurs calculées de l'erreur de reconstruction (x) et déterminer cet indicateur comme étant un indicateur d'évaluation (BI) pour évaluer au moins un élément parmi une performance, un état et une condition de charge du stockage de batterie (10).

2. Procédé selon la revendication 1, dans lequel l'indicateur calculé est la variance d'au moins certaines des valeurs calculées de l'erreur de reconstruction (x).

3. Procédé selon la revendication 1 ou 2, dans lequel l'indicateur calculé est la variance des N plus grandes valeurs parmi les valeurs calculées de l'erreur de reconstruction (x), dans lequel N est un entier naturel qui est inférieur au nombre de multiples segments temporels (72).

4. Procédé selon l'une quelconque des revendications précédentes, dans lequel ladite obtention d'une série (70) de mesures d'au moins un paramètre physique du stockage de batterie (10) inclut de mesurer la série (70) de mesures du au moins un paramètre physique du stockage de batterie (10).

5. Procédé selon l'une quelconque des revendications précédentes, dans lequel l'auto-encodeur (40) comporte :

une couche de masquage (412) de l'encodeur (400) pour remplir et/ou masquer la série (70) de mesures entrées dans la couche d'entrée (410) de l'encodeur (400), et une couche interne (418) ayant une dimension qui est inférieure à une dimension de la couche d'entrée (410) de l'encodeur (400), dans lequel le procédé comporte les étapes consistant à :

mapper, par l'encodeur (400) de l'auto-encodeur (40), la série (70) de mesures entrée à une représentation interne de celle-ci dans la couche interne (418), et mapper, par le décodeur (420) de l'auto-encodeur (40), la représentation interne de la série (70) de mesures entrée à une série reconstruite (80) de mesures.

**6.** Procédé selon l'une quelconque des revendications 1 à 5, dans lequel le procédé est un procédé de détermination d'un indicateur d'évaluation pour évaluer une performance ou un état d'un stockage de batterie, et dans lequel le au moins un paramètre physique inclut une tension.

**7.** Procédé selon l'une quelconque des revendications 1 à 5, dans lequel le procédé est un procédé de détermination d'un indicateur d'évaluation pour évaluer une condition de charge d'un stockage de batterie, et dans lequel le au moins un paramètre physique inclut un courant.

**8.** Procédé selon l'une quelconque des revendications précédentes, dans lequel le procédé comporte en outre de déterminer un état de santé du stockage de batterie (10) sur la base de l'indicateur calculé et sur la base d'une valeur de référence.

**9.** Procédé de surveillance d'au moins un élément parmi une performance, un état et une condition de charge d'un stockage de batterie, le procédé comportant les étapes consistant à :

déterminer un indicateur d'évaluation pour évaluer le au moins un élément parmi une performance, un état et une condition de charge du stockage de batterie (10) selon le procédé de l'une quelconque des revendications 1 à 8 précédentes, pendant une période d'évaluation (74) ;
répéter l'étape de détermination de l'indicateur d'évaluation pendant une nouvelle période d'évaluation (74), tant que l'indicateur d'évaluation déterminé n'a pas encore atteint une valeur critique associée ; et
générer un signal d'erreur si l'indicateur d'évaluation déterminé a atteint la valeur critique associée.

**10.** Procédé selon l'une quelconque des revendications précédentes, dans lequel le procédé comporte en outre l'étape consistant à :
entraîner l'auto-encodeur (40) en utilisant des séries de mesures du au moins un paramètre physique du stockage de batterie (10), dans lequel les mesures de chaque série de mesures correspondent à des points successifs dans le temps d'un segment temporel d'apprentissage associé parmi de multiples segments temporels d'apprentissage d'une période d'apprentissage.

**11.** Système pour déterminer un indicateur d'évaluation pour évaluer au moins un élément parmi une performance, un état et une condition de charge d'un stockage de batterie, le système comportant :
des moyens de calcul (30), dans lequel les moyens de calcul (30) sont configurés pour réaliser les étapes du procédé de l'une quelconque des revendications précédentes, dans lequel les moyens de calcul (30) comportent l'auto-encodeur (40).

Fig. 1

400    420

410  412  414  416  418  422  424  426

70    80

40

Fig. 2

72  72  72  72  72  72  72  72  72  72

74

Fig. 3

Fig. 4

Fig. 5

# Fig. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102020117609 B4
- WO 2022034116 A1
- CN 113917334 A

**Non-patent literature cited in the description**

- Analytical Investigation of Anomaly Detection Methods based on Time-Domain Features and Autoencoders in Satellite Power Subsystem. **WEIHUA et al.** 2101 8TH INTERNATIONAL CONFERENCE ON DEPENDABLE SYSTEMS AND THEIR APPLICATIONS (DSA). IEEE, 05 August 2021, 451-460

- An Autocorrelation-based LSTM-Autoencoder for Anomaly Detection on Time-Series Data. **HAJAR et al.** 2020 IEEE INTERNATIONAL CONFERENCE ON BIG DATA (BIG DATA). IEEE, 10 December 2020, 5068-5077